# FASCICULE DE BREVET EUROPEEN

(11) **EP 3 479 384 B1**
(45) Date de publication et mention de la délivrance du brevet: **04.03.2020**
(21) Numéro de dépôt: 17732456.3
(22) Date de dépôt: 26.06.2017
(51) Int. Cl.: G21G 1/10

(54) **INSTALLATION COMPACTE DE PRODUCTION DE RADIO-ISOTOPES**
KOMPAKTE ANLAGE ZUR HERSTELLUNG VON RADIOISOTOPEN
COMPACT FACILITY FOR PRODUCING RADIOISOTOPES

(30) Priorité: 29.06.2016 FR 1656109
(43) Date de publication de la demande: 08.05.2019
(73) Titulaire: Aima Developpement, 06200 Nice (FR)
(72) Inventeur: MANDRILLON, Pierre, 06640 Saint-Jeannet (FR); MANDRILLON, Jérôme, 06200 NICE (FR)
(74) Mandataire: Nony
(86) Numéro de dépôt international: PCT/EP2017/065731
(87) Numéro de publication internationale: WO 2018/001974

(56) Documents cités:
- FR-A1- 2 332 676
- FR-A1- 2 997 603
- US-A- 6 130 926

## Description

La présente invention concerne la production de radio-isotopes, et plus particulièrement mais non exclusivement ceux à usage médical, tels que ¹⁸F, ¹¹C, ¹³N ou ¹⁵O.

Certains radio-isotopes sont de plus en plus utilisés dans la fabrication de marqueurs d'imagerie médicale ou pour la radio-immunothérapie.

Leur demi-vie est relativement courte, ce qui encourage une production à proximité du lieu d'utilisation.

Ces radio-isotopes sont produits en irradiant une cible par un faisceau de particules accélérées.

Les cyclotrons constituent des accélérateurs particulièrement appropriés pour cette production car relativement compacts comparativement aux accélérateurs linéaires. Néanmoins, leur implantation s'accompagne de mesures de radioprotection qui rendent l'installation finalement encore assez encombrante et problématique.

Il existe par conséquent un besoin pour faciliter la production de radio-isotopes et notamment pour bénéficier d'une installation compacte, fiable, et facile à implanter à proximité des centres d'utilisation, voire des patients à examiner par imagerie TEP.

L'invention vise à y répondre et elle y parvient grâce à une installation de production de radio-isotopes, comportant :
- au moins une cible apte à recevoir un composé à irradier avec un faisceau de particules accéléré,
- un cyclotron pour produire ledit faisceau de particules accéléré, comportant au moins une cavité accélératrice au sein de laquelle le faisceau est soumis à un champ électrique radiofréquence afin d'être accéléré et à un champ magnétique lui permettant de parcourir plusieurs fois la cavité en décrivant des orbites autour d'un axe Z du cyclotron, ce champ magnétique étant produit par au moins une bobine, installation dans laquelle la cible est intérieure à la bobine lorsque celle-ci est observée selon l'axe Z du cyclotron, la bobine étant non symétrique de révolution autour de cet axe Z.

Une telle installation présente de nombreux avantages.

Tout d'abord, le fait que la cible soit intérieure à la bobine permet de profiter de la culasse du cyclotron en tant que blindage radio-protecteur vis-à-vis du rayonnement émis par la cible, ce qui réduit d'autant le besoin de radioprotection extérieure à cette culasse et permet de diminuer significativement le poids et l'encombrement de l'installation.

Ensuite, la forme non symétrique de révolution de la bobine permet de créer un espace au sein du cyclotron où loger la cible tout en gardant une installation compacte.

La bobine peut ainsi présenter une distance à l'axe Z qui varie et la cible est de préférence adjacente à une région choisie parmi la ou les régions les plus éloignées de l'axe Z. La bobine peut présenter un rayon de courbure qui varie et la cible être adjacente à une région choisie parmi la ou les régions de plus petit rayon de courbure. La bobine peut présenter une forme générale polygonale et la cible être située dans le voisinage d'un coin du polygone. La bobine peut notamment présenter une forme générale triangulaire, carrée ou rectangulaire, de préférence carrée.

L'espace précité peut être mis à profit pour y loger non seulement la cible mais aussi un blindage de radioprotection de la bobine, s'étendant entre la cible et la bobine, ce qui réduit la dose reçue par les matériaux isolants composant la bobine, prolongeant ainsi sa durée de vie.

Le faisceau de particules accélérées peut s'étendre entre des altitudes z1 et z2 selon l'axe Z du cyclotron et la bobine peut s'étendre au moins partiellement dans cet intervalle d'altitudes [zl, z2]. Autrement dit, avec une telle configuration, si la cible n'était pas interne, l'extraction du faisceau ne pourrait se faire sans intercepter la bobine.

Le cyclotron peut être de tout type, et de préférence le cyclotron est à secteurs magnétiques, ceux-ci étant de préférence au nombre de quatre. Ces secteurs définissent des régions à champ fort appelées collines et d'autres à champ faible, appelées vallées.

Les secteurs assurent la déviation des particules accélérées afin de leur permettre de décrire des orbites autour de l'axe Z, et d'être accélérées jusqu'à l'énergie nécessaire. Ces secteurs peuvent être formés par des pôles opposés de la culasse du cyclotron, laquelle est préférentiellement en acier magnétique.

De préférence, comme évoqué ci-dessus, l'installation comporte un blindage radio-protecteur entre la cible et la ou les bobines, et ce blindage est de préférence en plomb.

De préférence, le blindage épouse localement sensiblement la forme de l'arrière du secteur magnétique. Le blindage peut épouser sensiblement la forme du volume entre l'arrière du secteur et la bobine.

De préférence également, la bobine est unique. Dans ce cas, elle traverse le plan médian. En variante, deux bobines rapprochées axialement peuvent être utilisées.

Le cyclotron peut avoir une culasse de contour extérieur de forme quelconque, mais de préférence de forme générale sensiblement homothétique de celle de la bobine, lorsqu'observée selon l'axe Z. En vue selon l'axe Z, la culasse peut être de contour de forme générale carrée, de côtés parallèles à ceux de la bobine lorsque celle-ci est de forme générale carrée.

Le cyclotron peut comporter une chambre à vide, éventuellement délimitée notamment à sa périphérie par un matériau magnétique, notamment de l'acier magnétique, de préférence celui de la culasse. En variante, la chambre à vide est délimitée au moins partiellement par une paroi rapportée sur la culasse, par exemple en acier ou en aluminium. La chambre à vide peut être délimitée par une paroi intégrée à un pôle inférieur ou supérieur, cette paroi comportant de préférence une gorge de joint.

Les particules accélérées par la/les cavité(s) accélératrice(s) peuvent être des ions H⁻ ou des ions D⁻.

La distance de parcours des particules accélérées dans la cible est de préférence supérieure ou égale à 8 cm pour une cible gazeuse, ce qui permet un rendement de production de radio-isotopes relativement élevé.

La cible peut être reçue dans un logement ménagé dans la culasse du cyclotron, ce logement étant de préférence formé par usinage.

L'invention a encore pour objet, selon un autre de ses aspects, l'utilisation d'une installation selon l'invention, telle que définie ci-dessus, pour la production de radio-isotopes, de préférence à usage médical, notamment ¹⁸F, ¹¹C, ¹³N ou ¹⁵O.

L'invention a encore pour objet le cyclotron compact en tant que tel.

L'invention pourra être mieux comprise à la lecture de la description détaillée qui va suivre, d'exemples non limitatifs de mise en œuvre de celle-ci, et à l'examen du dessin annexé, sur lequel :
- la figure 1 est une vue schématique en perspective d'un exemple d'installation, faisant apparaître certains éléments constitutifs en transparence,
- la figure 2 est une coupe partielle au niveau du plan médian d'accélération du cyclotron de l'installation de la figure 1,
- la figure 3 représente en perspective un détail de l'ensemble cible et son support,
- la figure 4 illustre l'extraction du faisceau sur la cible,
- la figure 5 est une coupe illustrant un détail de réalisation du blindage entourant la cible,
- les figures 6 et 7 représentent des variantes d'usinage du logement de réception de la cible,
- la figure 8 représente une possibilité de chambre à vide particulièrement simple qui relie les pôles supérieur et inférieur.
- les figures 9 et 10 sont deux coupes, respectivement prises dans l'axe des collines et dans l'axe des vallées, illustrant la possibilité d'utiliser deux bobines rapprochées.

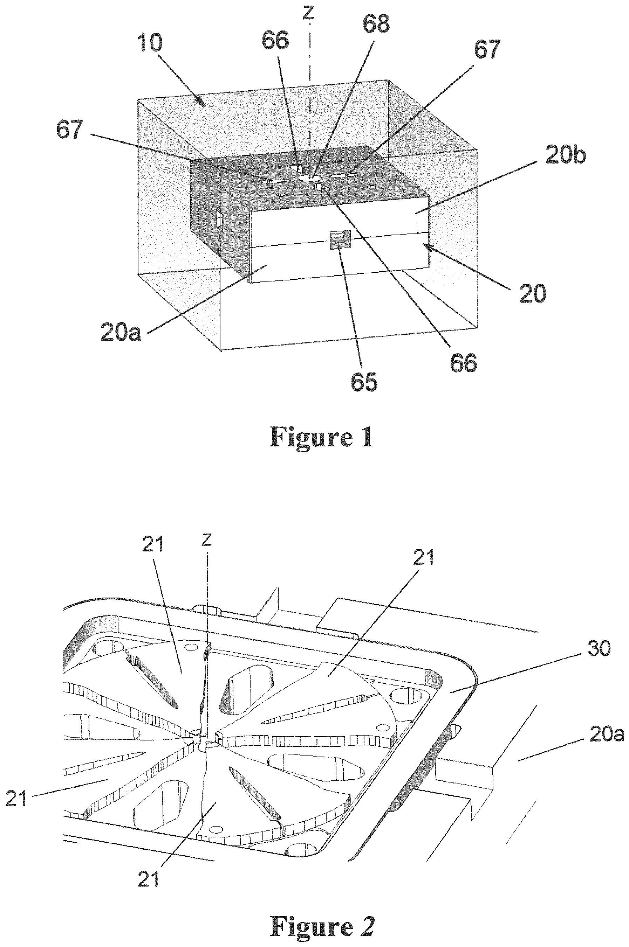

L'installation 10 selon l'invention, représentée à la figure 1, comporte un auto-blindage léger contenant le cyclotron compact, dont on aperçoit la culasse 20 par transparence.

Le cyclotron comporte de façon connue en soi une source d'ions à accélérer, non représentée, qui peut être interne ou externe, en un emplacement central 68.

Les ions produits par la source sont par exemple des ions H⁻ ou D⁻, mais l'invention n'est pas limitée à un type d'ions particuliers.

La culasse 20 comporte des parties inférieure 20a et supérieure 20b assemblées, en acier magnétique.

Dans l'exemple considéré, et comme illustré plus particulièrement sur la figure 2, le cyclotron présente quatre secteurs magnétiques 21 formés avec la culasse. Les parties 20a et 20b constituent les retours de culasse. L'invention n'est pas limitée à un nombre de secteurs particuliers.

Le plan médian d'accélération XY est perpendiculaire à l'axe Z du cyclotron, autour duquel s'effectuent les orbites.

Les ions H⁻ /D⁻ voient leur trajectoire s'incurver sous l'effet du champ magnétique régnant entre les pôles dans les collines, ce champ étant sensiblement parallèle à l'axe Z de la machine.

Un champ électrique radiofréquence (HF) permet d'accélérer les particules de façon connue en soi. Il est produit par des cavités accélératrices formant chacune un résonateur radiofréquence situé entre les secteurs. Ces cavités ont trois parties distinctes : les électrodes, appelées « dees » dont le bord définit les espaces accélérateurs, leurs supports appelés « stems » et l'ensemble de la masse HF du résonateur appelé « liner ». Les stems assurent la liaison entre les électrodes et le liner. Ils sortent par des trous 66 dans la culasse 20. La puissance HF est amenée dans le cyclotron par une boucle de couplage située dans les trous 66.

On voit sur la figure 1, outre l'emplacement des trous 66 pour le passage des stems, des trous 67 réservés pour le pompage du cyclotron.

Le champ magnétique est généré par une bobine 30 interne au cyclotron, disposée autour des pôles magnétiques du cyclotron, au sein de la culasse 20.

Cette bobine 30 est de préférence à conducteurs électriques rangés, par exemple disposés sous la forme de plusieurs couches empilées selon l'axe Z, formées chacune par plusieurs spires s'étendant parallèlement au plan XY.

La bobine 30 s'étend axialement selon l'axe Z dans un intervalle d'altitudes Z₁ à Z₂, qui contient l'altitude 0 du plan médian XY d'accélération. La bobine 30 traverse donc le plan médian XY.

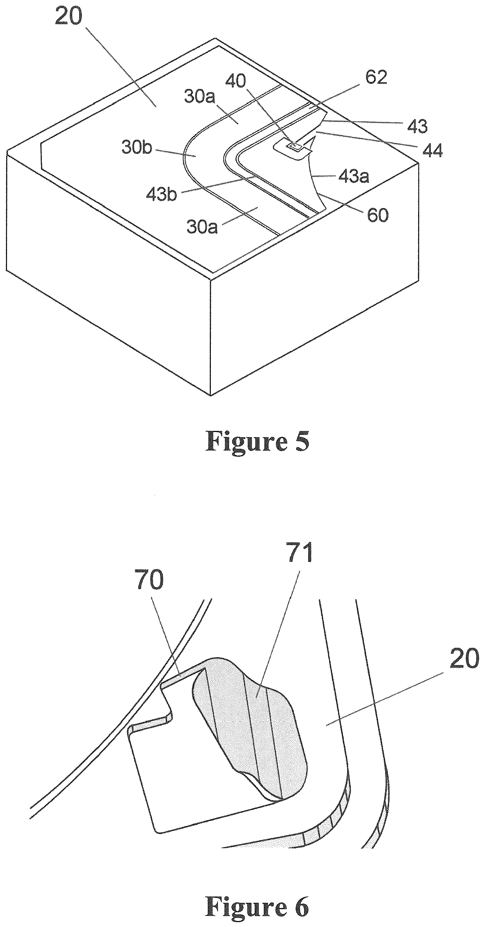

La bobine 30 présente, lorsqu'observée de dessus, selon l'axe Z, une forme générale sans symétrie de révolution, de contour par exemple polygonal, notamment de forme générale carrée, comme illustré. Plus précisément, dans l'exemple considéré, et comme visible plus particulièrement sur la figure 5, la bobine 30 s'étend selon des segments de droite 30a disposés comme les côtés du carré, reliés par des arrondis 30b du fait de la courbure minimale qu'il convient de respecter pour ne pas endommager les conducteurs électriques.

Cette forme polygonale permet de ménager dans les coins de la bobine 30, du côté radialement intérieur de celle-ci, des espaces pouvant recevoir chacun une cible 40. Dans l'exemple considéré, l'installation ne comporte qu'une cible 40, mais en variante elle en comporte plusieurs. L'épaisseur totale de la cible, selon l'axe Z, est par exemple comprise entre 50 et 60 mm.

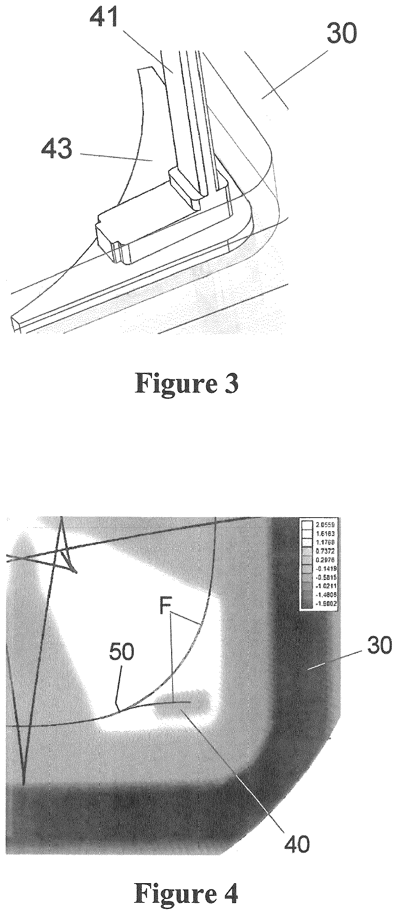

Le faisceau F de particules accélérées est dirigé vers cette cible 40, qui contient le composé à transmuter. Celui-ci est de préférence sous forme gazeuse pour faciliter son acheminement et son extraction de la cible 40 par au moins un conduit 41 qui s'étend par exemple parallèlement à l'axe Z, comme illustré à la figure 3.

L'énergie du faisceau est par exemple comprise entre 2 et 20 MeV.

La culasse 20 étant fermée, l'acier magnétique de celle-ci contribue au blindage radioprotecteur.

La hauteur de la culasse peut être comprise entre 300 et 500 mm.

Si l'on se reporte à la figure 4, on voit qu'un éplucheur d'électrons 50 pour les ions négatifs peut être disposé sur la dernière orbite pour éplucher les ions H⁻/D⁻ et les transformer en ions H⁺/ D⁺ en vue de leur extraction vers la cible 40. La cible 40 est ainsi placée à proximité de l'éplucheur 50, sur le trajet des ions H⁺ / D⁺ épluchés.

La cible 40 est placée à l'intérieur d'un blindage 43 radio-protecteur, de préférence en plomb, visible sur la figure 5.

Ce blindage 43 est reçu avec la cible 40 dans un logement 60 réalisé par exemple par usinage de la culasse, dans l'espace ménagé grâce à l'angle donné localement à la bobine 30.

Le blindage 43 peut épouser localement, sur son côté radialement intérieur 43a, la forme du secteur, et sur son côté radialement extérieur 43b, la forme de la bobine 30.

Dans les plans XZ et YZ, l'implantation du blindage 43 s'effectue sensiblement au raz de la culasse 20, sans géométrie complexe à contourner.

Différents matériaux peuvent être utilisés pour réaliser le blindage 43, mais le plomb est préféré.

Une paroi de chambre à vide 62, en aluminium par exemple, peut isoler la bobine 30 de l'intérieur du cyclotron et garantir l'étanchéité au vide. La bobine 30 se trouve donc dans l'air.

Le blindage 43 est parcouru par un canal 44 par lequel le faisceau est acheminé jusqu'à la cible 40.

Une sortie 65 peut être ménagée dans la culasse 20, comme visible sur la figure 1, pour la sortie des conducteurs électriques reliés à la bobine.

L'emprise au sol de la culasse 20 en tant que telle est de préférence inférieure à 1,5 m².

L'invention n'est pas limitée à l'exemple qui vient d'être décrit. En particulier, les connexions électriques des bobines peuvent être placées différemment de même que les connexions hydrauliques pour leur refroidissement. Le cyclotron peut être sans secteurs.

La figure 6 illustre une possibilité d'usinage spécifique de la culasse 20 autour de la cible, avec un renfoncement 70 ne s'étendant que d'un côté d'un passage 71 pour le conduit de sortie 41, non apparent sur cette figure. Cela peut permettre de bénéficier d'une énergie légèrement plus élevée, mais complique l'usinage des pôles pour adapter le renfoncement 70 à la géométrie de la cible.

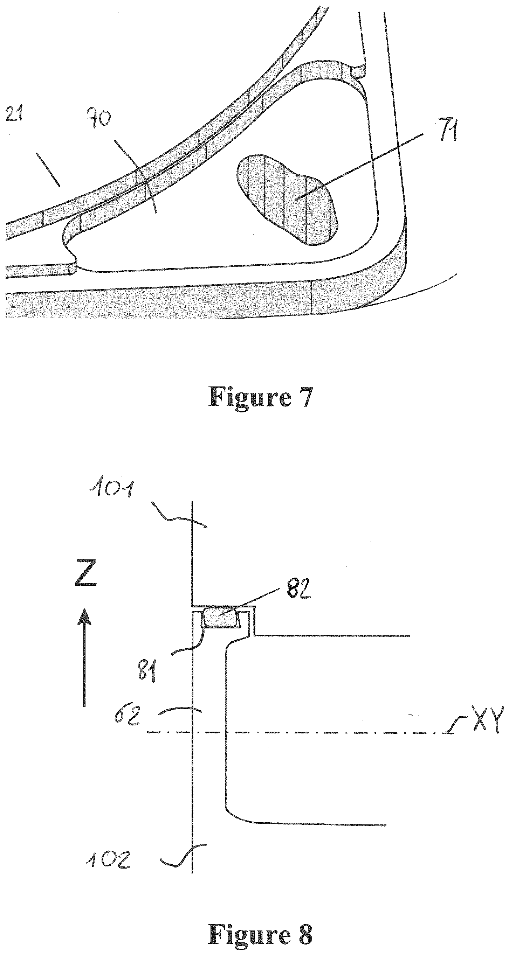

En variante, l'angle de la culasse est complètement usiné, comme illustré à la figure 7, ce qui présente l'avantage de simplifier la fabrication, d'offrir davantage de place pour la cible et d'améliorer la radioprotection.

La figure 8 illustre la possibilité d'intégrer la paroi verticale 62 de la chambre à vide au pôle inférieur 102 avec une gorge de joint 81 recevant un joint 82 pour assurer l'étanchéité entre les pôles supérieur 101 et inférieur 102 assemblés. Cela diminue le coût de fabrication.

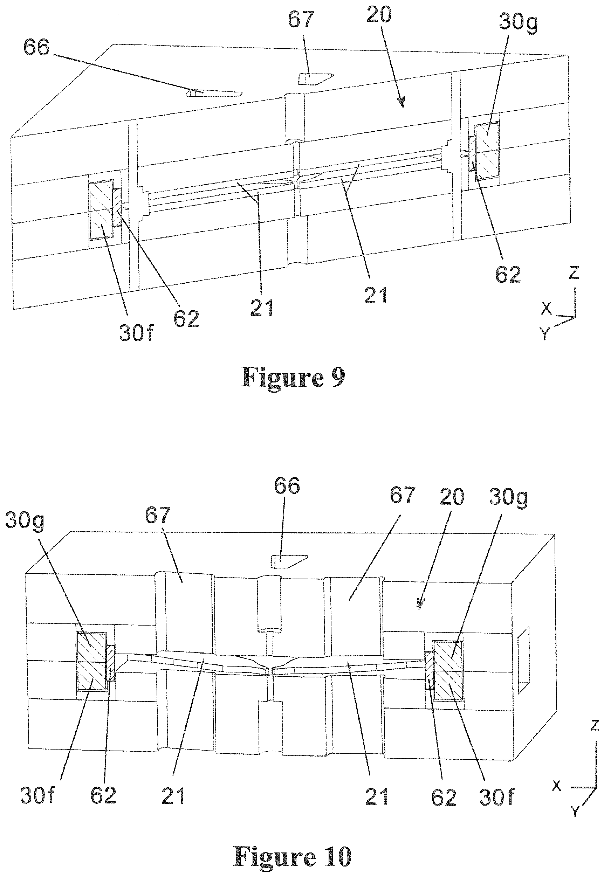

Sur les figures 9 et 10, on a illustré la possibilité de réaliser la bobine 30 avec deux parties superposées disjointes 30f et 30g, très proches l'une de l'autre.

L'expression « comportant un » doit être comprise comme étant synonyme de « comprenant au moins un ».

## Revendications

1. Installation de production de radio-isotopes, comportant :
- au moins une cible (40) apte à recevoir un composé à irradier avec un faisceau de particules accéléré,
- un cyclotron pour produire ledit faisceau de particules accéléré, comportant au moins une cavité accélératrice au sein de laquelle le faisceau est soumis à un champ électrique radiofréquence afin d'être accéléré et à un champ magnétique lui permettant de parcourir plusieurs fois la cavité en décrivant des orbites autour d'un axe (Z) du cyclotron, ce champ magnétique étant produit par au moins une bobine (30),
**caractérisée en ce que**, dans ladite installation la cible (40) est intérieure à la bobine (30) lorsque celle-ci est observée selon l'axe (Z) du cyclotron, la bobine (30) étant non symétrique de révolution autour de cet axe (Z).

2. Installation selon la revendication 1, la bobine (30) présentant une distance à l'axe (Z) qui varie et la cible (40) étant adjacente à une région de la bobine choisie parmi la ou les plus éloignées de l'axe (Z).

3. Installation selon la revendication 1 ou 2, la bobine présentant un rayon de courbure qui varie et la cible étant adjacente à une région de la bobine choisie parmi la ou les régions de plus petit rayon de courbure autour de l'axe (Z).

4. Installation selon l'une quelconque des revendications précédentes, la bobine présentant une forme générale polygonale et la cible étant située dans le voisinage d'un coin du polygone, la bobine présentant de préférence une forme triangulaire, carrée ou rectangulaire, mieux carrée.

5. Installation selon l'une quelconque des revendications précédentes, le faisceau de particules accélérées s'étendant entre des altitudes z1 et z2 selon l'axe (Z) du cyclotron et la bobine s'étendant au moins partiellement dans cet intervalle d'altitudes [z1,z2].

6. Installation selon l'une quelconque des revendications précédentes, le cyclotron comportant des secteurs magnétiques (21), de préférence au nombre de quatre.

7. Installation selon l'une quelconque des revendications précédentes, comportant un blindage (43), de préférence en plomb, entre la cible (40) et la ou les bobines (30).

8. Installation selon la revendication précédente, le blindage (43) épousant sensiblement la forme du volume entre l'arrière du secteur et la bobine.

9. Installation selon l'une quelconque des revendications précédentes, la bobine (30) étant unique et traversant le plan médian (XY).

10. Installation selon l'une quelconque des revendications précédentes, le cyclotron ayant une culasse magnétique (20) de contour extérieur de même forme générale que la bobine, notamment de forme générale carrée, lorsqu'observée selon ledit axe (Z).

11. Installation selon l'une quelconque des revendications précédentes, le cyclotron comportant une chambre à vide au moins partiellement délimitée par de l'acier magnétique, notamment à sa périphérie, la chambre à vide étant de préférence délimitée par une paroi intégrée à un pôle inférieur ou supérieur, cette paroi comportant une gorge de joint (81).

12. Installation selon l'une quelconque des revendications précédentes, les particules accélérées par la cavité accélératrice étant des ions H⁻ ou D⁻

13. Installation selon l'une quelconque des revendications précédentes, la distance de parcours des particules accélérées dans la cible (40) étant supérieure ou égale à 8cm pour une cible gazeuse.

14. Installation selon l'une quelconque des revendications précédentes, la cible étant reçue dans un logement (70) formé dans une culasse magnétique du cyclotron, ce logement étant de préférence formé par usinage.

15. Utilisation d'une installation selon l'une quelconque des revendications précédentes pour la production de radio-isotopes, de préférence à usage médical, notamment ¹⁸F, ¹¹C, ¹³N, ¹⁵O.

## Patentansprüche

1. Anlage zur Herstellung von Radioisotopen, welche umfasst:
- wenigstens ein Target (40), das geeignet ist, eine mit einem beschleunigten Teilchenstrahl zu bestrahlende Verbindung aufzunehmen,
- ein Zyklotron zur Erzeugung des beschleunigten Teilchenstrahls, das wenigstens einen Beschleunigungsraum aufweist, in dessen Innerem der Strahl einem elektrischen Hochfrequenzfeld ausgesetzt wird, um beschleunigt zu werden, und einem Magnetfeld, welches ihm ermöglicht, den Raum mehrere Male zu durchlaufen und dabei Umläufe um eine Achse (Z) des Zyklotrons auszuführen, wobei dieses Magnetfeld von wenigstens einer Spule (30) erzeugt wird,
**dadurch gekennzeichnet, dass** sich in der Anlage das Target (40) innerhalb der Spule (30) befindet, wenn diese entlang der Achse (Z) des Zyklotrons betrachtet wird, wobei die Spule (30) nicht rotationssymmetrisch um diese Achse (Z) ist.

2. Anlage nach Anspruch 1, wobei die Spule (30) einen Abstand zur Achse (Z) aufweist, welcher variiert, und das Target (40) einem Bereich der Spule benachbart ist, der aus dem- oder denjenigen ausgewählt ist, die am weitesten von der Achse (Z) entfernt sind.

3. Anlage nach Anspruch 1 oder 2, wobei die Spule einen Krümmungsradius aufweist, welcher variiert, und das Target einem Bereich der Spule benachbart ist, der aus dem oder den Bereichen mit dem kleinsten Krümmungsradius um die Achse (Z) ausgewählt ist.

4. Anlage nach einem der vorhergehenden Ansprüche, wobei die Spule eine vieleckige allgemeine Form aufweist und das Target sich in der Nähe einer Ecke des Vielecks befindet, wobei die Spule vorzugsweise eine dreieckige, quadratische oder rechteckige, am besten eine quadratische Form aufweist.

5. Anlage nach einem der vorhergehenden Ansprüche, wobei sich der Strahl beschleunigter Teilchen zwischen den Höhen z1 und z2 entlang der Achse (Z) des Zyklotrons erstreckt und die Spule sich wenigstens teilweise in diesem Höhenintervall [zl, z2] erstreckt.

6. Anlage nach einem der vorhergehenden Ansprüche, wobei das Zyklotron Magnetsektoren (21) aufweist, deren Anzahl vorzugsweise vier ist.

7. Anlage nach einem der vorhergehenden Ansprüche, welche eine Abschirmung (43), vorzugsweise aus Blei, zwischen dem Target (40) und der oder den Spulen (30) aufweist.

8. Anlage nach dem vorhergehenden Anspruch, wobei die Abschirmung (43) im Wesentlichen an die Form des Volumens zwischen der hinteren Seite des Sektors und der Spule angepasst ist.

9. Anlage nach einem der vorhergehenden Ansprüche, wobei die Spule (30) eine einzige ist und die Mittelebene (XY) durchquert.

10. Anlage nach einem der vorhergehenden Ansprüche, wobei das Zyklotron ein Magnetjoch (20) mit einer Außenkontur mit derselben allgemeinen Form wie die Spule aufweist, insbesondere mit einer quadratischen allgemeinen Form, entlang der Achse (Z) betrachtet.

11. Anlage nach einem der vorhergehenden Ansprüche, wobei das Zyklotron eine Vakuumkammer aufweist, die wenigstens teilweise von magnetischem Stahl begrenzt wird, insbesondere an ihrem Umfang, wobei die Vakuumkammer vorzugsweise von einer Wand begrenzt wird, die in einen unteren oder oberen Pol integriert ist, wobei diese Wand eine Dichtungsnut (81) aufweist.

12. Anlage nach einem der vorhergehenden Ansprüche, wobei die durch den Beschleunigungsraum beschleunigten Teilchen H⁻- oder D⁻-Ionen sind.

13. Anlage nach einem der vorhergehenden Ansprüche, wobei die Weglänge der beschleunigten Teilchen in dem Target (40) größer oder gleich 8 cm für ein gasförmiges Target ist.

14. Anlage nach einem der vorhergehenden Ansprüche, wobei das Target in einer Aufnahme (70) aufgenommen ist, die in einem Magnetjoch des Zyklotrons ausgebildet ist, wobei diese Aufnahme vorzugsweise durch Bearbeitung ausgebildet ist.

15. Verwendung einer Anlage nach einem der vorhergehenden Ansprüche zur Erzeugung von Radioisotopen, vorzugsweise zur medizinischen Verwendung, insbesondere von ¹⁸F, ¹¹C, ¹³N, ¹⁵O.

## Claims

1. A facility for producing radioisotopes, comprising:
- at least one target (40) able to receive a compound to be irradiated with an accelerated particle beam,
- a cyclotron for producing said accelerated particle beam, comprising at least one accelerating cavity within which the beam is subjected to a radiofrequency electric field in order to be accelerated and to a magnetic field enabling it to travel through the cavity several times, describing orbits about an axis (Z) of the cyclotron, this magnetic field being produced by at least one coil (30),
**characterized in that**, in which facility, the target (40) is inside the coil (30) when the latter is observed along the axis (Z) of the cyclotron, the coil (30) not having symmetry of revolution about this axis (Z).

2. The facility as claimed in claim 1, the coil (30) having a varying distance to the axis (Z) and the target (40) being adjacent to a region of the coil chosen from the region or regions furthest from the axis (Z).

3. The facility as claimed in claim 1 or 2, the coil having a varying radius of curvature and the target being adjacent to a region of the coil chosen from the region or regions having the smallest radius of curvature about the axis (Z).

4. The facility as claimed in any one of the preceding claims, the coil having a generally polygonal shape and the target being located in the vicinity of a corner of the polygon, the coil preferably having a triangular, square or rectangular shape, better still a square shape.

5. The facility as claimed in any one of the preceding claims, the accelerated particle beam extending between altitudes z1 and z2 along the axis (Z) of the cyclotron and the coil extending at least partially into this interval of altitudes [z1,z2].

6. The facility as claimed in any one of the preceding claims, the cyclotron comprising magnetic sectors (21), preferably four in number.

7. The facility as claimed in any one of the preceding claims, comprising a shielding (43), preferably made of lead, between the target (40) and the coil or coils (30).

8. The facility as claimed in the preceding claim, the shielding (43) substantially matching the shape of the space between the rear of the sector and the coil.

9. The facility as claimed in any one of the preceding claims, the coil (30) being singular and passing through the median plane (XY).

10. The facility as claimed in any one of the preceding claims, the cyclotron having a magnetic yoke (20) with an outer contour of the same general shape as the coil, especially of a generally square shape, when observed along said axis (Z).

11. The facility as claimed in any one of the preceding claims, the cyclotron comprising a vacuum chamber at least partially delimited by magnetic steel, especially at the periphery thereof, the vacuum chamber preferably being delimited by a wall integrated to a lower or upper pole, this wall comprising a seal groove (81).

12. The facility as claimed in any one of the preceding claims, the particles accelerated by the accelerating cavity being H⁻ or D⁻ ions.

13. The facility as claimed in any one of the preceding claims, the distance traveled by the accelerated particles in the target (40) being greater than or equal to 8 cm for a gaseous target.

14. The facility as claimed in any one of the preceding claims, the target being accommodated in a housing (70) formed in a magnetic yoke of the cyclotron, this housing preferably being formed by machining.

15. The use of a facility as claimed in any one of the preceding claims for the production of radioisotopes, preferably for medical use, especially ¹⁸F, ¹¹C, ¹³N and ¹⁵O.
